# EUROPÄISCHE PATENTSCHRIFT

(11) **EP 2 331 974 B1**
(45) Veröffentlichungstag und Bekanntmachung des Hinweises auf die Patenterteilung: **10.05.2017**
(21) Anmeldenummer: 09781454.5
(22) Anmeldetag: 04.08.2009
(51) Int. Cl.: G01P 15/08, B81B 3/00

(54) **SENSOR UND VERFAHREN ZUR HERSTELLUNG EINES SENSORS**
SENSOR AND METHOD FOR THE PRODUCTION OF A SENSOR
CAPTEUR ET PROCÉDÉ POUR FABRIQUER UN CAPTEUR

(30) Priorität: 25.09.2008 DE 102008042366
(43) Veröffentlichungstag der Anmeldung: 15.06.2011
(73) Patentinhaber: Robert Bosch GmbH, 70442 Stuttgart (DE)
(72) Erfinder: WELLNER, Patrick, 70184 Stuttgart (DE); PATAK, Christian, 72762 Reutlingen (DE); TEBJE, Lars, 72770 Reutlingen (DE); GRUTZECK, Helmut, 72127 Maehringen (DE); MATERNA, Volker, 99817 Eisenach (DE)
(86) Internationale Anmeldenummer: PCT/EP2009/060073
(87) Internationale Veröffentlichungsnummer: WO 2010/034554

(56) Entgegenhaltungen:
- EP-A- 0 773 443
- EP-A- 1 947 053
- US-A- 5 181 156
- US-A1- 2008 110 260

## Beschreibung

### Stand der Technik

Die Erfindung geht aus von einem Sensor nach dem Oberbegriff des Anspruchs 1.

Solche Sensoren sind allgemein bekannt. Beispielsweise ist aus der Druckschrift DE 10 2006 026 880 A1 ein mikromechanischer Beschleunigungssensor mit einer in z-Richtung auslenkbaren Schwungmasse in Form einer Wippe bekannt, wobei zur Vermeidung von asymmetrischem Clipping, bei unterschiedlich langen Hebelarmen der Wippe auf der Seite des kürzeren Hebelarms eine die mögliche Auslenkung verkürzende Anschlagseinrichtung vorgesehen ist. Nachteilig an dieser Anordnung zur Verkürzung der möglichen Auslenkung der Schwungmasse in z-Richtung ist, dass durch eine einseitige elektrostatische Wechselwirkung zwischen der Schwungmasse und der Anschlagseinrichtung das Verhalten der Schwungmasse beeinflusst wird. Ferner geht aus der Druckschrift DE 198 00 574 A1 ein Beschleunigungssensor mit einem Kappenwafer zur Abdeckung einer mikromechanischen Struktur des Beschleunigungssensors hervor.

Ferner ist aus der Druckschrift EP 1 947 053 A2 eine Sensorstruktur bekannt, welche eine als Wippenstruktur ausgebildete seismische Masse umfasst, die zwischen einem Substrat und einer Verkappung angeordnet ist. Die Verkappung weist zwei Anschläge auf, welche eine maximale Auslenkung der seismischen Masse in Richtung der Verkappung begrenzen. Die zwei Anschläge weisen einen gleich großen Überdeckungsbereich jeweils mit der seismischen Masse auf, so dass sich die elektrostatischen Wechselwirkungen zwischen dem einen Anschlag und der seismischen Masse und dem anderen Anschlag und der seismischen Masse gegenseitig kompensieren.

### Offenbarung der Erfindung

Der erfindungsgemäße Sensor und das erfindungsgemäße Verfahren zur Herstellung eines Sensors gemäß den nebengeordneten Ansprüchen haben gegenüber dem Stand der Technik den Vorteil, dass einerseits die Auslenkung der seismischen Masse durch den ersten und zweiten Anschlag begrenzt wird und andererseits das Verhalten der seismischen Masse durch den ersten und den zweiten Anschlag nicht oder nur unwesentlich beeinflusst wird. Darüberhinaus ist der erfindungsgemäße Sensor vergleichsweise einfach und kostengünstig herstellbar, da aufgrund der Ausbildung des ersten und des zweiten Anschlags als Teil der Kappe zur Anordnung des ersten und zweiten Anschlags lediglich die Kappe auf dem Substrat angeordnet werden muss. Ferner werden beim erfindungsgemäßen Sensor die Fertigungstoleranzen insbesondere bei der Positionierung der Kappe auf dem Substrat parallel zur Haupterstreckungsebene erheblich erhöht. Dies wird dadurch erreicht, dass der erste und der zweite Überdeckungsbereich im Wesentlichen gleich groß sind, so dass insbesondere bei einem elektrisch leitfähigen Kontakt zwischen dem ersten und dem zweiten Anschlag über die restliche Kappe eine erste elektrostatische Wechselwirkung zwischen dem ersten Bereich und dem ersten Anschlag gleich einer zweiten elektrostatischen Wechselwirkung zwischen dem zweiten Bereich und einem zweiten Anschlag ist. Somit kompensieren sich die ersten und zweiten elektrostatischen Wechselwirkungen auf die seismische Masse und es wirkt kein oder nur ein unwesentliches resultierendes Drehmoment auf die seismische Masse mit einer Drehachse parallel zur Haupterstreckungsebene. Der erste und der zweite Anschlag werden mittels der Kappe insbesondere derart auf dem Substrat angeordnet, dass sich bei einer Verschiebung der Kappe relativ zum Substrat parallel zur Haupterstreckungsebene die Größe des ersten Überdeckungsbereichs gleich der Größe des zweiten Übergangsbereichs verändert und somit die Kappe weniger genau auf dem Substrat positioniert werden muss, aber dennoch eine Kompensation zwischen der ersten und der zweiten elektrostatischen Wechselwirkung erzielt wird. Insbesondere eine Messung einer Beschleunigung senkrecht zur Haupterstreckungsebene, d.h. in z-Richtung, wird durch den ersten und den zweiten Anschlag nicht oder nur unwesentlich beeinflusst. Ferner wird beispielsweise auch eine Messung einer Beschleunigung parallel zur Haupterstreckungsebene, d.h. in x- und/oder y-Richtung, durch den ersten und zweiten Anschlag nicht oder nur unwesentlich beeinflusst, da die erste und zweite elektrostatische Wechselwirkung höchstens eine gleichmäßige Kraftwirkung auf die seismische Masse in z-Richtung haben und somit eine Verkippung der seismischen Masse um die Drehachse parallel zur Haupterstreckungsebene verhindert wird, wobei durch eine derartige Verkippung insbesondere die Gefahr einer Verlagerung des Massenschwerpunktes der seismischen Masse in x- und/oder y-Richtung und somit einer Verfälschung der Messung bestünde.

Vorteilhafte Ausgestaltungen und Weiterbildungen der Erfindung sind den Unteransprüchen, sowie der Beschreibung unter Bezugnahme auf die Zeichnungen zu entnehmen.

Gemäß einer weiteren bevorzugten Weiterbildung ist vorgesehen, dass die seismische Masse senkrecht zur Haupterstreckungsebene im Wesentlichen zwischen dem Substrat und der Kappe angeordnet ist, so dass in vorteilhafter Weise die seismische Masse auf der einen Seite durch das Substrat und auf der anderen Seite durch die Kappe geschützt wird. Vorzugsweise sind zwischen der seismischen Masse und dem Substrat Elektroden auf dem Substrat und entsprechenden Gegenelektroden an der seismischen Masse angeordnet, so dass eine Auslenkung der seismischen Masse relativ zum Substrat und senkrecht zur Haupterstreckungsebene eine Veränderung der elektrischen Kapazität zwischen Elektroden und Gegenelektroden verursacht und somit quantifizierbar ist.

Es ist vorgesehen, dass die seismische Masse als Wippenstruktur ausgebildet ist, wobei eine Schwenkachse der Wippenstruktur parallel zur Haupterstreckungsebene im Wesentlichen zwischen dem ersten und dem zweiten Bereich angeordnet ist. Besonders bevorzugt weist die seismische Masse bezüglich der Schwenkachse eine asymmetrische Massenverteilung auf, so dass eine senkrecht zur Haupterstreckungsebene wirkende Beschleunigungskraft ein Drehmoment auf die seismische Masse um die Schwenkachse bewirkt, wobei eine erste Auslenkung vorzugsweise eine Drehung in einer ersten Drehrichtung um die Schwenkachse herum und eine zweite Auslenkung eine Drehung in einer der ersten Drehrichtung entgegengesetzten zweiten Drehrichtung um die Schwenkachse herum umfasst. Der erste Anschlag begrenzt in vorteilhafter Weise eine maximale erste Auslenkung, während der zweite Anschlag eine maximale zweite Auslenkung begrenzt.

Es ist ferner vorgesehen, dass die seismische Masse eine erste seismische Teilmasse und eine zweite seismische Teilmasse umfasst, wobei die erste seismische Teilmasse den ersten Bereich und die zweite seismische Teilmasse den zweiten Bereich aufweist, wobei die erste und die zweite seismische Teilmasse vorzugsweise durch Stege miteinander verbunden sind. Besonders vorteilhaft ist somit in vergleichsweise einfacher und raumsparender Weise eine Wippenstruktur mit asymmetrischer Massenverteilung gegenüber der Schwenkachse realisierbar, wobei die erste seismische Teilmasse eine Masse ungleich der zweiten seismischen Teilmasse aufweist oder wobei der
Massenschwerpunkt der ersten seismischen Teilmasse einen Abstand zur Schwenkachse aufweist, welcher ungleich dem Abstand des Massenschwerpunktes der zweiten seismischen Teilmassen von der Schwenkachse ist.

Ferner ist vorgesehen, dass der erste Bereich einen ersten Randbereich der ersten seismischen Teilmasse und der zweite Bereich einen zweiten Randbereich der zweiten seismischen Teilmasse umfasst, so dass der erfindungsgemäße Sensor vergleichsweise bauraumkompakt realisierbar ist und eine Größenveränderung des ersten Überdeckungsbereichs durch eine Verschiebung des ersten Anschlags parallel zur Haupterstreckungsebene relativ zum ersten Randbereich eine gleiche Größenveränderung des zweiten Überdeckungsbereichs bewirkt, da vorzugsweise mit dem ersten Anschlag über die Kappe zwangsläufig auch der zweite Anschlag in gleicher Weise relativ zum zweiten Randbereich parallel zur Haupterstreckungsebene verschoben wird.

Es ist vorgesehen, dass der erste und der zweite Anschlag bezüglich der seismischen Masse derart angeordnet sind, dass eine erste elektrostatische Wechselwirkung zwischen dem ersten Anschlag und dem ersten Bereich im Wesentlichen identisch einer zweiten elektrostatischen Wechselwirkung zwischen dem zweiten Anschlag und dem zweiten Bereich vorgesehen ist, so dass sich die erste und zweite elektrostatische Wechselwirkungen in vorteilhafter Weise gegenseitig kompensieren und somit das Verhalten der seismischen Masse insbesondere bei einer Beschleunigungswirkung senkrecht zur Haupterstreckungsebene nicht oder nur unwesentlich beeinflusst wird.

Gemäß einer weiteren bevorzugten Weiterbildung ist vorgesehen, dass der Sensor einen mikromechanischen Sensor und insbesondere einen mikromechanischen Beschleunigungssensor umfasst, welcher vorzugsweise gegenüber Beschleunigungskräften senkrecht zur Haupterstreckungsebene sensitiv vorgesehen ist.

Ein weiterer Gegenstand der vorliegenden Erfindung ist ein Verfahren zur Herstellung eines Sensors, wobei in einem Montageschritt die Kappe zusammen mit dem ersten und dem zweiten Anschlag derart auf dem Substrat angeordnet wird, dass der erste und der zweite Überdeckungsbereich im Wesentlichen gleich groß sind, so dass sich, wie oben bereits ausgeführt, die erste und die zweite elektrostatische Wechselwirkung gegenseitig kompensieren und somit das Verhalten der seismischen Masse nicht oder nur unwesentlich beeinflussen. Besonders vorteilhaft werden ferner in lediglich einem einzigen Montageschritt der erste und der zweite Anschlag gleichzeitig angeordnet und somit die Gleichheit des ersten und zweiten Überdeckungsbereichs sichergestellt. Durch die feste Verbindung zwischen erstem und zweiten Anschlag werden darüberhinaus die Fertigungstoleranzen erhöht, da eine Größenveränderung des ersten Überdeckungsbereichs automatisch auch zu eine gleichsamen Größenveränderung des zweiten Überdeckungsbereichs führt. Insbesondere muss somit die Kappe auf dem Substrat dadurch deutlich weniger genau positioniert werden.

Ausführungsbeispiele der Erfindung sind in den Zeichnungen dargestellt und in der nachfolgenden Beschreibung näher erläutert.

### Kurze Beschreibung der Zeichnungen

### Es zeigen

**Figur 1** eine schematische Perspektivansicht eines Substrat und einer seismischen Masse eines Sensors gemäß einer ersten Ausführungsform der vorliegenden Erfindung,
**Figur 2** eine schematische Perspektivansicht einer Kappe eines Sensors gemäß der ersten Ausführungsform der vorliegenden Erfindung,
**Figur 3** eine schematische Perspektivansicht eines Sensors gemäß der ersten Ausführungsform der vorliegenden Erfindung,
**Figur 4** eine schematische Perspektivansicht eines Sensors gemäß einer zweiten Ausführungsform der vorliegenden Erfindung,
**Figur 5** eine schematische Perspektivansicht eines Sensors gemäß einer dritten Ausführungsform der vorliegenden Erfindung und
**Figur 6** eine schematische Perspektivansicht eines Sensors.

### Ausführungsformen der vorliegenden Erfindung

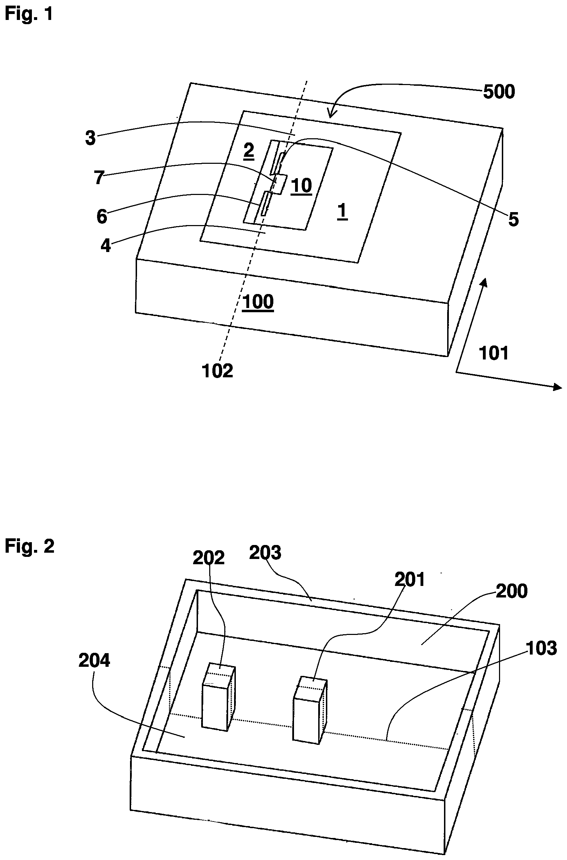

In **Figur 1** ist eine schematische Perspektivansicht eines Substrat 100 und einer seismischen Masse 500 eines Sensors gemäß einer ersten Ausführungsform der vorliegenden Erfindung dargestellt, wobei das Substrat 100 eine Haupterstreckungsebene 101 aufweist und die seismische Masse 500 in einer Ebene parallel zur Haupterstreckungsebene 101 vollständig umschließt. Die seismische Masse 500 umfasst eine erste seismische Teilmasse 1 und eine zweite seismische Teilmasse 2, wobei die erste und die zweite seismische Teilmasse 1, 2 durch einen ersten und einen zweiten Steg 3, 4 miteinander verbunden sind. Zwischen der ersten und der zweiten seismischen Teilmasse 1, 2 und zwischen dem ersten und zweiten Steg 3, 4 ist ein Freiraum 10 ausgebildet. Alternativ umfasst der Freiraum 10 ein Gebiet, welches auf dem elektrischen Potential des Substrats 100 liegt. In dem Freiraum 10 ist ein Verankerungselement 7 angeordnet, welches mit dem Substrat 100 verbunden ist. Die seismische Masse 500 ist mittels Aufhängungsfedern 5 an dem Verankerungselement 7 befestigt, so dass eine Bewegung der seismischen Masse 500 relativ zum Substrat 100 ermöglicht wird. Die Aufhängungsfedern 5 greifen vorzugsweise an dem ersten und zweiten Steg 3, 4 an und definieren somit insbesondere eine Schwenkachse 102 parallel zur Haupterstreckungsebene 101. Die erste und die zweite seismische Teilmasse 1, 2 umfassen eine unterschiedliche Masse und der Schwerpunkt der ersten seismischen Teilmasse weist einen Abstand zur Schwenkachse 102 auf, welcher ungleich einem Abstand des Schwerpunkts der zweiten seismischen Teilmasse zur Schwenkachse 102 ist, so dass die seismische Masse 500 als eine um die Schwenkachse 102 auslenkbare Wippenstruktur mit einer bezüglich der Schwenkachse 102 asymmetrischen Massenverteilung ausgebildet ist. Eine auf den Sensor wirkende Beschleunigungskraft senkrecht zur Haupterstreckungsebene 101, d.h. in z-Richtung, erzeugt somit eine Auslenkung der seismischen Masse 500 um die Schwenkachse 102.

In **Figur 2** ist eine schematische Perspektivansicht einer Kappe 200 eines Sensors gemäß der ersten Ausführungsform der vorliegenden Erfindung dargestellt, wobei die Kappe 200 einen Hohlraum 204 aufweist, in welchem ein erster und ein zweite Anschlag 201, 202 angeordnet ist und wobei die Kappe 200 einen den Hohlraum 204 parallel zur Haupterstreckungsebene 101 umlaufenden Rahmen 203 aufweist. Der erste und der zweite Anschlag 201, 202 sind über die restliche Kappe elektrisch leitfähig miteinander verbunden und liegen daher im Wesentlichen auf dem gleichen elektrischen Potential.

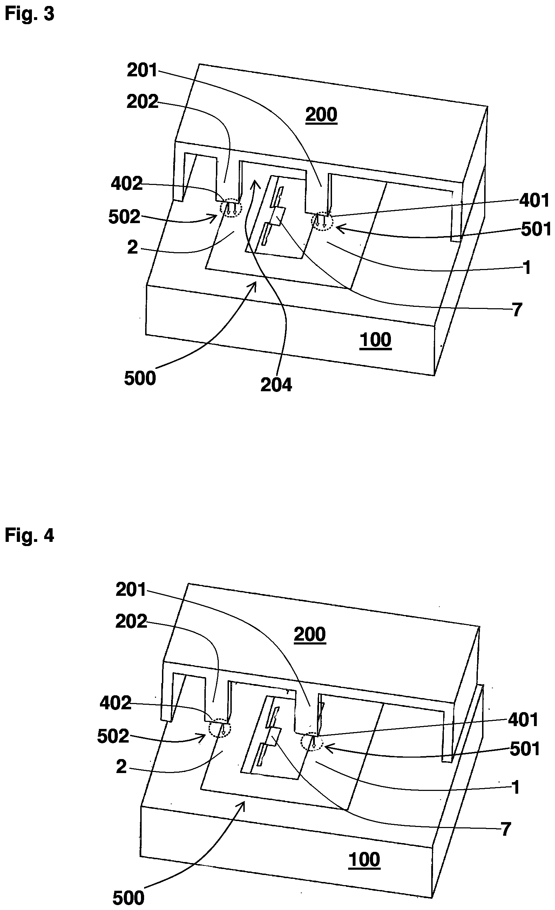

In **Figur 3** ist eine schematische Perspektivansicht eines Sensors gemäß der ersten Ausführungsform der vorliegenden Erfindung dargestellt, wobei die Figur 3 im Wesentlichen identisch der Figur 1 ist und zusätzlich die Kappe 200 aus Figur 2 darstellt. Die Kappe 200 ist im Unterschied zur Figur 2 aus Gründen der Übersichtlichkeit jedoch in einer Schnittdarstellung illustriert, wobei die Schnittdarstellung eines Schnittes durch die Kappe 200 entlang der in Figur 2 dargestellten Schnittlinie 103 entspricht. Ferner ist die Kappe 200 relativ zum Substrat 100 derart ausgerichtet, dass der erste und zweite Anschlag 201, 202 in Richtung der seismischen Masse 500 zeigen und der Hohlraum 204 in Richtung der seismischen Masse 500 geöffnet ist. Die Kappe 200 ist über den Rahmen 203 mit dem Substrat 100, insbesondere über eine stoffschlüssige Verbindung, wie beispielsweise durch Kleben, Verglasen, anodisches Bonden o.ä., fest verbunden, wobei die seismische Masse 500 senkrecht zur Haupterstreckungsebene 101 zwischen Substrat 100 und Kappe 200 angeordnet ist. In einem ersten Überdeckungsbereich 401 überdeckt senkrecht zur Haupterstreckungsebene 101 der erste Anschlag 201 einen ersten Bereich 501 der seismischen Masse 500, während in einem zweiten Überdeckungsbereich 402 der zweite Anschlag 202 einen zweiten Bereich 502 der seismischen Masse 500 überdeckt, wobei der erste Bereich 501 auf der ersten seismischen Teilmasse 1 und der zweite Bereich 502 auf der zweiten seismischen Teilmasse 2 angeordnet ist. Der Größe des ersten Überdeckungsbereichs 401 ist dabei parallel zur Haupterstreckungsebene 101 im Wesentlichen der Größe des zweiten Überdeckungsbereichs 402 identisch, so dass eine erste elektrostatische Wechselwirkung zwischen dem ersten Bereich 501 und dem ersten Anschlag 201 im Wesentlichen gleich groß einer zweiten elektrostatischen Wechselwirkung zwischen dem zweiten Bereich 502 und dem zweiten Anschlag 202 ist. Die erste und zweite elektrostatische Wechselwirkung kompensieren sich somit im Hinblick auf das Auslenkungsverhalten der seismischen Masse 500 um die Schwenkachse 102 gegenseitig, so dass keine oder nur eine unwesentlichen Beeinflussung des Auslenkungsverhaltens durch den ersten und/oder den zweiten Anschlag 201, 202 vorliegt. Insbesondere wird ein resultierendes Drehmoment auf die seismische Masse aufgrund der Kompensation der ersten und der zweiten elektrostatischen Wechselwirkung vermieden. Die erste und zweite elektrostatische Wechselwirkung sind dabei mittels der Pfeile schematisch angedeutet. Der erste und der zweite Bereich 501, 502 weisen dazu vorzugsweise den gleichen Abstand zur Schwenkachse 102 auf. Der erste Anschlag 201 ist senkrecht zur Haupterstreckungsebene 101 von dem ersten Bereich 501 derart beabstandet, dass eine erste Auslenkung der seismischen Masse 500 um die Schwenkachse 102 durch eine Berührung zwischen dem ersten Anschlag 201 und dem ersten Bereich 501 begrenzt wird, während der zweite Anschlag 202 senkrecht zur Haupterstreckungsebene 102 vorzugsweise gleichermaßen von dem zweiten Bereich 502 beabstandet ist, so dass eine der ersten Auslenkung entgegengesetzte zweite Auslenkung der seismischen Masse 500 um die Schwenkachse 102 durch eine Berührung zwischen dem zweiten Anschlag 202 und dem zweiten Bereich 502 begrenzt wird. Eine Beschädigung des Sensors durch zu große erste und zweite Auslenkungen der seismischen Masse 500 wird somit unterbunden.

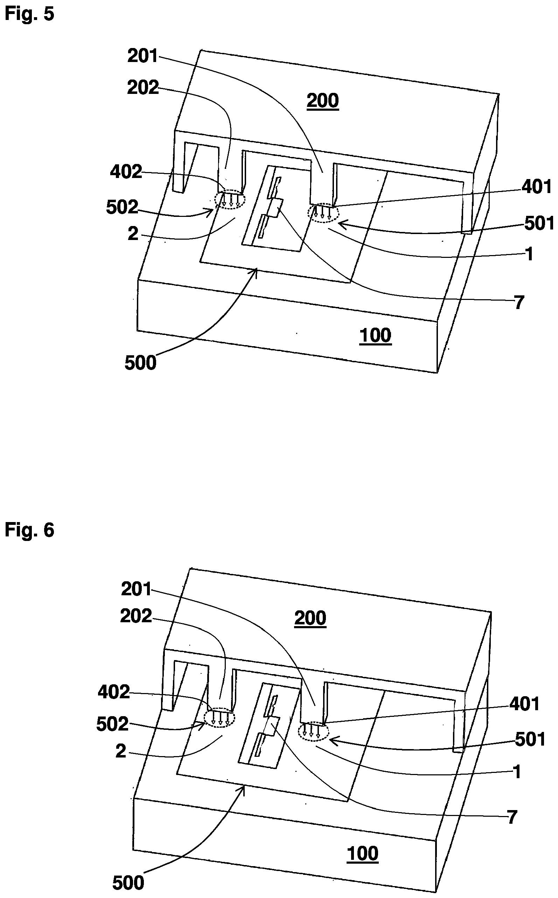

In den **Figuren 4** **und** **5** sind schematische Perspektivansichten von Sensoren gemäß einer zweiten und dritten Ausführungsform der vorliegenden Erfindung dargestellt, wobei die zweite und dritte Ausführungsform im Wesentlichen jeweils identisch der ersten Ausführungsform illustriert in Figur 3 sind, wobei im Unterschied jeweils die Kappe 200 relativ zum Substrat 100 in einer Richtung parallel zur Haupterstreckungsebene 101 leicht verschoben ist. Der erste Bereich 501 umfasst daher zumindest in der zweiten Ausführungsform einen ersten Randbereich der ersten seismischen Teilmasse 1 und der zweite Bereich 502 einen zweiten Randbereich der zweiten seismischen Teilmasse 2. Da der erste und der zweite Anschlag 201, 202 als Teil der Kappe 200 ausgebildet sind, ist der Abstand zwischen dem ersten und dem zweiten Anschlag 201 und 202 jeweils konstant, so dass durch die Verschiebung der Kappe 200 relativ zum Substrat 100 der erste und der zweite Überdeckungsbereich 401, 402 um den gleichen Betrag in der Größe verändert werden. Die Größen des ersten und zweiten Überdeckungsbereichs 401, 402 sind somit unabhängig von einer Verschiebung der Kappe 200 relativ zum Substrat 100 und liegen auf dem gleichen elektrischen Potential, so dass sich die erste und die zweite elektrostatische Wechselwirkung auch unabhängig von einer Verschiebung der Kappe 200 relativ zum Substrat 100 im Wesentlichen gegenseitig kompensieren und kein oder nur ein vergleichsweise geringes resultierendes Drehmoment auf die seismische Masse 500 wirkt. Besonders vorteilhaft werden somit die Fertigungstoleranzen bei der Positionierung der Kappe 200 auf dem Substrat 100 erheblich erhöht.

In **Figur 6** ist eine schematische Perspektivansicht eines Sensors dargestellt, der im Wesentlichen identisch der dritten Ausführungsform dargestellt in Figur 5 ist, wobei der Freiraum 10 kleiner und die erste seismische Teilmasse 1 größer ausgebildet ist. Der erste und der zweite Bereich 501, 502 umfassen somit nicht mehr einen ersten und einen zweiten Randbereich, wobei sich dennoch die erste und die zweite elektrostatische Wechselwirkung im Wesentlichen gegenseitig kompensieren.

## Patentansprüche

1. Sensor mit einem Substrat (100), einer Kappe (200) und einer seismischen Masse (500), wobei das Substrat (100) eine Haupterstreckungsebene (101) aufweist, wobei die seismische Masse (500) senkrecht zur Haupterstreckungsebene (101) auslenkbar vorgesehen ist, wobei in einem ersten Überdeckungsbereich (401) ein erster Anschlag (201) der Kappe (200) einen ersten Bereich (501) der seismischen Masse (500) senkrecht zur Haupterstreckungsebene (101) überdeckt und wobei in einem zweiten Überdeckungsbereich (402) ein zweiter Anschlag (202) der Kappe (200) einen zweiten Bereich (502) der seismischen Masse (500) senkrecht zur Haupterstreckungsebene (101) überdeckt, wobei die seismische Masse (500) als Wippenstruktur ausgebildet ist, wobei eine Schwenkachse (102) der Wippenstruktur parallel zur Haupterstreckungsebene (101) im Wesentlichen zwischen dem ersten und dem zweiten Bereich (501, 502) angeordnet ist, wobei der erste und der zweite Bereich (501, 502) einen gleichen Abstand zur Schwenkachse (102) aufweisen, wobei der erste und der zweite Anschlag (201, 202) bezüglich der seismischen Masse (500) derart angeordnet sind, dass der erste und der zweite Überdeckungsbereich (401, 402) parallel zur Haupterstreckungsebene (101) im Wesentlichen gleich groß sind und eine erste elektrostatische Wechselwirkung (601) zwischen dem ersten Anschlag (201) und dem ersten Bereich (502) im Wesentlichen identisch einer zweiten elektrostatischen Wechselwirkung (602) zwischen dem zweiten Anschlag (202) und dem zweiten Bereich (502) ist, wobei die seismische Masse (500) eine erste seismische Teilmasse (1) und eine zweite seismische Teilmasse (2) umfasst und wobei die erste seismische Teilmasse (1) den ersten Bereich (501) und die zweite seismische Teilmasse (2) den zweiten Bereich (502) aufweist, **dadurch gekennzeichnet, dass** der erste Bereich (501) einen ersten Randbereich der ersten seismischen Teilmasse (1) und der zweite Bereich (502) einen zweiten Randbereich der zweiten seismischen Teilmasse (2) derart umfasst, dass eine Größenveränderung des ersten Überdeckungsbereichs (401) durch eine Verschiebung des ersten Anschlags (201) parallel zur Haupterstreckungsebene (101) relativ zum ersten Randbereich eine gleiche Größenveränderung des zweiten Überdeckungsbereichs (402) bewirkt.

2. Sensor nach Anspruch 1, **dadurch gekennzeichnet, dass** die seismische Masse (500) senkrecht zur Haupterstreckungsebene (101) im Wesentlichen zwischen dem Substrat (100) und der Kappe (200) angeordnet ist.

3. Sensor nach einem der vorhergehenden Ansprüche, **dadurch gekennzeichnet, dass** der Sensor einen mikromechanischen Sensor und insbesondere einen mikromechanischen Beschleunigungssensor umfasst, welcher vorzugsweise gegenüber Beschleunigungskräften senkrecht zur Haupterstreckungsebene (101) sensitiv vorgesehen ist.

4. Verfahren zur Herstellung eines Sensors nach einem der vorhergehenden Ansprüche, **dadurch gekennzeichnet, dass** in einem Montageschritt die Kappe (200) zusammen mit dem ersten und dem zweiten Anschlag (201, 202) derart auf dem Substrat (100) angeordnet wird, dass der erste und der zweite Überdeckungsbereich (401, 402) im Wesentlichen gleich groß sind und dass eine Größenveränderung des ersten Überdeckungsbereichs (401) durch eine Verschiebung des ersten Anschlags (201) parallel zur Haupterstreckungsebene (101) relativ zum ersten Randbereich eine gleiche Größenveränderung des zweiten Überdeckungsbereichs (402) bewirkt.

## Claims

1. Sensor comprising a substrate (100), a cap (200) and a seismic mass (500), wherein the substrate (100) has a main extension plane (101), wherein the seismic mass (500) is provided to be deflectable perpendicular to the main extension plane (101), wherein in a first coverage region (401) a first stop (201) of the cap (200) covers a first region (501) of the seismic mass (500) perpendicular to the main extension plane (101) and wherein in a second coverage region (402) a second stop (202) of the cap (200) covers a second region (502) of the seismic mass (500) perpendicular to the main extension plane (101), wherein the seismic mass (500) is formed as a rocker structure, wherein a pivot axis (102) of the rocker structure is arranged parallel to the main extension plane (101) substantially between the first and the second region (501, 502), wherein the first and the second region (501, 502) have an equal spacing from the pivot axis (102), wherein the first and the second stop (201, 202) are arranged with respect to the seismic mass (500) in such a way that the first and the second coverage region (401, 402) parallel to the main extension plane (101) are substantially the same size and a first electrostatic interaction (601) between the first stop (201) and the first region (502) is substantially identical to a second electrostatic interaction (602) between the second stop (202) and the second region (502), wherein the seismic mass (500) comprises a first seismic partial mass (1) and a second seismic partial mass (2) and wherein the first seismic partial mass (1) has the first region (501) and the second seismic partial mass (2) has the second region (502), **characterized in that** the first region (501) comprises a first edge region of the first seismic partial mass (1) and the second region (502) comprises a second edge region of the second seismic partial mass (2) in such a way that a change in size of the first coverage region (401) caused by displacing the first stop (201) parallel to the main extension plane (101) relative to the first edge region brings about an identical change in size of the second coverage region (402).

2. Sensor according to Claim 1, **characterized in that** the seismic mass (500) is arranged perpendicular to the main extension plane (101) substantially between the substrate (100) and the cap (200).

3. Sensor according to either of the preceding claims, **characterized in that** the sensor comprises a micromechanical sensor and in particular a micromechanical acceleration sensor which is preferably provided to be sensitive to acceleration forces perpendicular to the main extension plane (101).

4. Method for producing a sensor according to one of the preceding claims, **characterized in that** the cap (200) is arranged, together with the first and the second stop (201, 202), on the substrate (100) in one assembly step in such a way that the first and the second coverage region (401, 402) are substantially the same size, and **in that** a change in size of the first coverage region (401) caused by displacing the first stop (201) parallel to the main extension plane (101) relative to the first edge region brings about an identical change in size of the second coverage region (402).

## Revendications

1. Capteur comportant un substrat (100), un capuchon (200) et une masse sismique (500), dans lequel le substrat (100) comporte un plan d'extension principal (101), dans lequel la masse sismique (500) est prévue de manière à pouvoir être déviée perpendiculairement au plan d'extension principal (101), dans lequel une première butée (201) du capuchon (200) recouvre une première région (501) de la masse sismique (500) dans une première région de recouvrement (401) perpendiculairement au plan d'extension principal (101) et dans lequel une deuxième butée (202) du capuchon (200) recouvre une deuxième région (502) de la masse sismique (500) dans une deuxième région de recouvrement (402) perpendiculairement au plan d'extension principal (101), dans lequel la masse sismique (500) est réalisée sous la forme d'une structure basculante, dans lequel un axe de pivotement (102) de la structure basculante est disposé sensiblement entre les première et deuxième régions (501, 502) parallèlement au plan d'extension principal (101), dans lequel les première et deuxième régions (501, 502) présentent une même distance à l'axe de pivotement (102), dans lequel les première et deuxième butées (201, 202) sont disposées par rapport à la masse sismique (500) de manière à ce que les première et deuxième régions de recouvrement (401, 402) aient sensiblement la même taille parallèlement au plan d'extension principal (101) et une première interaction électrostatique (601) entre la première butée (201) et la première région (502) est sensiblement identique à une deuxième interaction électrostatique (602) entre la deuxième butée (202) et la deuxième région (502), dans lequel la masse sismique (500) comprend une première masse sismique partielle (1) et une deuxième masse sismique partielle (2) et dans lequel la première masse sismique partielle (1) comporte la première région (501) et la deuxième masse sismique partielle (2) comporte la deuxième région (502), **caractérisé en ce que** la première région (501) comprend une première périphérie de la première masse sismique partielle (1) et la deuxième région (502) comprend une deuxième périphérie de la deuxième masse sismique partielle (2) de manière à ce qu'une modification de la taille de la première région de recouvrement (401) par un décalage de la première butée (201) parallèlement au plan d'extension principal (101) par rapport à la première périphérie provoque une même modification de la taille de la première région de recouvrement (402).

2. Capteur selon la revendication 1, **caractérisé en ce que** la masse sismique (500) est disposée sensiblement entre le substrat (100) et le capuchon (200) perpendiculairement au plan d'extension principal (101).

3. Capteur selon l'une quelconque des revendications précédentes, **caractérisé en ce que** le capteur comprend un capteur micromécanique et notamment un capteur micromécanique d'accélération, qui est de préférence prévu de manière à ce qu'il soit sensible par rapport à des forces d'accélération perpendiculairement au plan d'extension principal (101).

4. Procédé d'établissement d'un capteur selon l'une quelconque des revendications précédentes, **caractérisé en ce que**, lors d'une étape de montage, le capuchon (200) est disposé sur le substrat (100) en association avec les première et deuxième butées (201, 202) de manière à ce que les première et deuxième régions de recouvrement (401, 402) aient sensiblement la même taille et **en ce qu'**une modification de la taille de la première région de recouvrement (401) par un décalage de la première butée (201) parallèlement au plan d'extension principal (101) provoque une même modification de la taille de la première région de recouvrement (402) par rapport à la première périphérie.
